(19) Europäisches Patentamt
European Patent Office
Office européen des brevets

(11) **EP 3 521 949 B1**

(12) **EUROPÄISCHE PATENTSCHRIFT**

(45) Veröffentlichungstag und Bekanntmachung des Hinweises auf die Patenterteilung:
**13.01.2021 Patentblatt 2021/02**

(51) Int Cl.:
***G05B 17/02*** *(2006.01)*

(21) Anmeldenummer: **18154633.4**

(22) Anmeldetag: **01.02.2018**

(54) **VORRICHTUNG ZUM SIMULIEREN EINER GESTEUERTEN MASCHINE ODER ANLAGE SOWIE VERFAHREN**

DEVICE FOR SIMULATING A CONTROLLED MACHINE OR INSTALLATION AND METHOD

DISPOSITIF DE SIMULATION D'UNE MACHINE OU D'UNE INSTALLATION COMMANDÉES AINSI QUE PROCÉDÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**07.08.2019 Patentblatt 2019/32**

(73) Patentinhaber: **Siemens Aktiengesellschaft 80333 München (DE)**

(72) Erfinder:
• **Ermler, Rene 91058 Erlangen (DE)**
• **Krebs, Cornelia 90607 Rückersdorf (DE)**
• **Neidig, Jörg 90409 Nürnberg (DE)**
• **Quiros Araya, Gustavo Princeton, 08540 (US)**

(56) Entgegenhaltungen:
**EP-A1- 2 980 661         WO-A1-2015/124170
DE-A1-102007 026 502**

**Beschreibung**

Die vorliegende Erfindung betrifft eine Vorrichtung zum Simulieren einer gesteuerten Maschine oder Anlage umfassend eine Prozesssimulationseinrichtung, welche dazu ausgebildet ist, zum Simulieren eines physikalischen Prozesses der Maschine oder Anlage Simulationsschritte durchzuführen. Zudem umfasst die Vorrichtung eine Steuerungssimulationseinrichtung, welche dazu ausgebildet ist, zum Simulieren einer Steuerung der Maschine oder Anlage Simulationsschritte durchzuführen. Dabei sind die Prozesssimulationseinrichtung und die Steuerungssimulationseinrichtung dazu ausgebildet, zum Simulieren der gesteuerten Maschine oder Anlage in den jeweiligen Simulationsschritten bestimmte Ausgangswerte auszutauschen. Zudem betrifft die vorliegende Erfindung ein Verfahren zum Simulieren einer gesteuerten Maschine oder Anlage.

Aus der DE 10 2007 026502 A1 ist bereits ein Trainingssystem für Bedienpersonal an einem Schiffs-Automatisierungssystem bekannt, umfassend einen Prozesssimulator und einen Steuerungssimulator, wobei die Simulation unterbrochen und danach weitergeführt werden kann, indem eine Aufnahme des Datenverkehrs zwischen dem Steuerungssimulator und einer Visualisierung des bisherigen Trainingsverlaufs in den Simulator erneut eingespielt wird.

Um ein automatisiertes System, wie eine gesteuerte Maschine, eine gesteuerte Anlage, eine Roboterzelle oder einen Produktionsprozess zu simulieren, ist es erforderlich, dass der physische Prozess in Kombination mit einer Simulation der Steuerung, beispielsweise des Steuerungsprogramms der Automatisierung, simuliert wird. In der Regel wird der physikalische Prozess mathematisch modelliert und mit entsprechenden Simulationswerkzeugen simuliert. Wenn die Untersuchung aber eine genaue Analyse der Regelstrecke fordert, ist es sinnvoll, dass das ursprüngliche Steuerungsprogramm in einer Software-emulierten Steuerung ausgeführt wird.

In diesem Fall besteht das Problem darin, dass sich ein physikalischer Prozess ständig ändert und zudem mit der Umgebung interagiert. Eine Steuerung hingegen interagiert nur zu bestimmten Zeitpunkten, die nicht allgemein im Voraus bekannt sind. Simulationswerkzeuge verfügen über eine eigene interne Schrittweitensteuerung für die Simulationsschritte, die bestimmt, für welche Zeitpunkte die Ergebnisse berechnet werden sollen. Diese Simulationsschritte sind nicht mit den Interaktionspunkten der Steuerung synchronisiert. Daher wird die Simulation insgesamt immer einen systematischen Simulationsfehler aufweisen, weil die Simulation des physikalischen Prozesses ihre Berechnung mit veralteten Eingabewerten der Simulation der Steuerung durchführt.

Bis jetzt wurde dieses Problem noch nicht gelöst. Das Verhalten der emulierten Steuerung ist eine exakte Nachbildung des Verhaltens einer realen Steuerung, beispielsweise einer speicherprogrammierbaren Steuerung. Hierbei gibt es einzelne Zeitpunkte, an denen eine Interaktion mit der Umgebung möglich ist, wobei diese im Allgemeinen unbekannt sind. Das Verhalten der Emulation kann nicht verändert werden, ohne dass die Gültigkeit des Simulationsergebnisses verloren geht. Wenn möglich, wird die Simulation des physikalischen Prozesses typischerweise auf eine feste Schrittweite gesetzt, um ein besser vorhersagbares Timing-Verhalten zu erhalten. Dies geht aber auf Kosten der Leistung und/oder der Genauigkeit. Der resultierende Simulationsfehler ist manchmal akzeptabel, mit anderen Worten kann die Simulation "gut genug" sein. Aber vor allem bei der Simulation von Systemen, in denen das Timing kritisch ist, sind die verfügbaren Setups nicht verwendbar. Der systematische Simulationsfehler kann durch eine erhebliche Reduzierung der Simulationsschrittweite reduziert werden. Dies führt jedoch zu einem höheren Rechenaufwand und einer geringeren Leistung.

Es ist Aufgabe der vorliegenden Erfindung, eine Lösung aufzuzeigen, wie eine gesteuerte Maschine oder Anlage mit geringem Rechenaufwand zuverlässiger simuliert werden kann.

Diese Aufgabe wird durch eine Vorrichtung nach Anspruch 1 sowie durch ein Verfahren nach Anspruch 10 mit den Merkmalen der jeweiligen unabhängigen Patentansprüche gelöst. Vorteilhafte Weiterbildungen der Erfindung sind in den abhängigen Patentansprüchen angegeben.

Eine erfindungsgemäße Vorrichtung zum Simulieren einer gesteuerten Maschine oder Anlage umfasst eine Prozesssimulationseinrichtung, welche dazu ausgebildet ist, zum Simulieren eines physikalischen Prozesses der Maschine oder Anlage Simulationsschritte durchzuführen. Zudem umfasst die Vorrichtung eine Steuerungssimulationseinrichtung, welche dazu ausgebildet ist, zum Simulieren einer Steuerung der Maschine oder Anlage Simulationsschritte durchzuführen. Die Prozesssimulationseinrichtung und die Steuerungssimulationseinrichtung sind dazu ausgebildet, zum Simulieren der gesteuerten Maschine oder Anlage in den jeweiligen Simulationsschritten bestimmte Ausgangswerte auszutauschen. Ferner ist es vorgesehen, dass die Steuerungssimulationseinrichtung dazu ausgebildet ist, an die Prozesssimulationseinrichtung eine Information zu übertragen, welche einen Ergebniszeitpunkt für ein Ende eines mit der Steuerungssimulationseinrichtung durchgeführten Simulationsschritts beschreibt. Außerdem ist die Prozesssimulationseinrichtung dazu ausgebildet, eine Zeitdauer zumindest eines Simulationsschritts in Abhängigkeit von dem Ergebniszeitpunkt anzupassen.

Mithilfe der Prozesssimulationseinrichtung kann das Verhalten der Maschine oder Anlage im Betrieb simuliert werden. Mit der Vorrichtung soll also ein automatisiertes System simuliert werden, welche eine Steuerung und die Maschine oder Anlage umfasst, wobei ein Betrieb der Maschine oder Anlage mittels der Steuerung gesteuert und/oder geregelt wird. Mittels der Steuerungssimulationseinrichtung kann das Verhalten der Steuerung beim Steuern beziehungsweise Regeln der Maschine oder Anlage simuliert werden. Insbesondere kann mittels der Steuerungssimulationseinrichtung eine Steuerung simuliert werden, welche als speicherprogrammierbare Steuerung (SPS) ausgebildet ist. Mit der Steuerungssimulationseinrichtung können die zeitlich aufeinanderfolgenden Simulationsschritte durchgeführt werden, um das Verhalten der speicherprogrammierbaren Steuerung nachzubilden. Beispielsweise kann mittels der Steuerungssimulationseinrichtung eine Regelstrecke zum Regeln der Maschinen oder Anlage simuliert werden. Die Steuerungssimulationseinrichtung umfasst insbesondere einen Emulator, auf welchem das reale Steuerungsprogramm der Steuerung zum Ablauf gebracht wird. Dies bringt den Vorteil mit sich, dass das Verhalten des realen Steuerprogramms untersucht werden kann. Somit ist es beispielsweise nicht erforderlich, dass das Verhalten der Steuerung beispielsweise mathematisch beschrieben wird und mit einem entsprechenden Simulationswerkzeug nachgebildet wird. Mit der Prozesssimulationseinrichtung können ebenfalls die zeitlich aufeinanderfolgen Simulationsschritte durchgeführt werden. In den jeweiligen Simulationsschritten werden Ausgangswerte bestimmt, welche das physikalische Verhalten der Maschine oder Anlage beschreiben. Beispielsweise können die Ausgangswerte eine Position, eine Geschwindigkeit, eine Beschleunigung oder dergleichen beschreiben.

Die jeweiligen Simulationsschritte, die mit der Steuerungssimulationseinrichtung und der Prozesssimulationseinrichtung durchgeführt werden, werden in Abhängigkeit von einer virtuellen Zeit bestimmt. Die Steuerungssimulationseinrichtung und die Prozesssimulationseinrichtung können beispielsweise sequentiell betrieben werden. Mittels der Steuerungssimulationseinrichtung können in den jeweiligen Simulationsschritten Ausgangswerte bestimmt werden und an die Prozesssimulationseinrichtung übertragen werden. Diese Ausgangswerte können von der Prozesssimulationseinrichtung als Eingangswerte für die nachfolgenden Simulationsschritte verwendet werden. In gleicher Weise können die Ausgangswerte, die mittels der Prozesssimulationseinrichtung bestimmt werden, als Eingangswerte für die nachfolgenden Simulationsschritte der Steuerungssimulationseinrichtung verwendet werden. Somit kann eine Co-Simulation ermöglicht werden.

Gemäß der vorliegenden Erfindung ist es vorgesehen, dass die Steuerungssimulationseinrichtung einen Ergebniszeitpunkt bestimmen, welcher einen Zeitpunkt beziehungsweise einen virtuellen Zeitpunkt beschreibt, an welchem einer der Simulationsschritte beendet wurde. Die Steuerungssimulationseinrichtung kann beispielsweise für jeden Simulationsschritt, der durchgeführt wird, einen Ergebniszeitpunkt bestimmen. Dieser Ergebniszeitpunkt wird dann von der Steuerungssimulationseinrichtung an die Prozesssimulationseinrichtung übertragen. Nach dem Empfangen kann die Prozesssimulationseinrichtung den zumindest einen Simulationsschritt, welcher nachfolgend mit dieser durchgeführt wird, an diesen Ergebniszeitpunkt anpassen. Insbesondere kann mit der Prozesssimulationseinrichtung eine Schrittweite beziehungsweise eine Zeitdauer des zumindest einen Simulationsschritts angepasst werden. Damit wird es ermöglicht, dass die Schrittweiten der Prozesssimulation dynamisch an die Schrittweiten der Simulation der Steuerung angepasst werden. Dadurch kann verhindert werden, dass in der Co-Simulation veraltete Eingangswerte verwendet werden und somit ein Simulationsfehler auftritt. Insgesamt kann somit die Simulation der gesteuerten Maschine oder Anlage zuverlässiger durchgeführt werden.

Bevorzugt ist die Prozesssimulationseinrichtung dazu ausgebildet, die Zeitdauer des zumindest einen Simulationsschritts, welcher mit dieser durchgeführt wird, so anzupassen, dass der zumindest eine Simulationsschritt zu dem Ergebniszeitpunkt endet. Mit der Steuerungssimulationseinrichtung kann beispielsweise ein Hauptzyklus der Steuerung simuliert werden. Der Ergebniszeitpunkt beschreibt, bis zu welcher virtuellen Zeit dieser Hauptzyklus simuliert wurde. Mit der Prozesssimulationseinrichtung können dann ein oder mehrere Simulationsschritte während eines Simulationszyklus durchgeführt werden. Die jeweilige zeitliche Dauer der Simulationsschritte kann so bestimmt werden, dass der Simulationszyklus zu dem Ergebniszeitpunkt endet. Somit können die Simulation des physikalischen Prozesses und die Simulation der Steuerung jeweils bis zu dem Ergebniszeitpunkt durchgeführt werden. Für nachfolgende Simulationszyklen können die jeweils bestimmten Ausgangswerte zwischen der Prozesssimulationseinrichtung und der Steuerungssimulationseinrichtung ausgetauscht werden. Somit kann verhindert werden, dass veraltete Ausgangswerte bei der Simulation verwendet werden.

Vorzugsweise weist die Prozesssimulationseinrichtung eine Einrichtung auf, welche dazu ausgebildet ist, die zeitliche Dauer des zumindest einen Simulationsschritts in Abhängigkeit von dem Ergebniszeitpunkt anzupassen. Sowohl die Prozesssimulationseinrichtung als auch die Steuerungssimulationseinrichtung können jeweils eine virtuelle Uhr umfassen. Anhand der virtuellen Uhr kann die Steuerungssimulationseinrichtung den Ergebniszeitpunkt bestimmen. Nach dem Empfangen des Ergebniszeitpunkts kann dann die Prozesssimulationseinrichtung ihre virtuelle Uhr nutzen, um zu bestimmen, wie die Schrittweiten der Simulationsschritte angepasst werden soll.

Erfindungsgemäß weist die Steuerungssimulationseinrichtung einen Ereignisgenerator auf, welcher dazu ausgebildet ist, ein Ereignissignal zu erzeugen, wobei das Ereignissignal den Ergebniszeitpunkt beschreibt. Zudem weist die Prozesssimulationseinrichtung einen Ereignisempfänger zum Empfangen des Ereignissignals auf. Mithilfe der Steuerungssimulationseinrichtung kann also ein Ereignis erzeugt werden, falls ein Simulationsschritt beendet wurde. Zusätzlich zu dem Ereignissignal kann die Steuerungssimulationseinrichtung auch die in dem Simulationsschritt bestimmen Ausgangswerte an die Prozesssimulationseinrichtung übertragen. Damit kann die Co-Simulation präzise durchgeführt werden.

Weiterhin ist es vorteilhaft, wenn die Steuerungssimulationseinrichtung dazu ausgebildet ist, die in einem Simulationsschritt bestimmten Ausgangswerte an die Prozesssimulationseinrichtung zu übertragen und die Prozesssimulationseinrichtung dazu ausgebildet ist, diese Ausgangswerte als Eingangswerte für den zumindest einen durchgeführten Simulationsschritt zu verwenden. Es kann auch vorgesehen sein, dass Prozesssimulationseinrichtung dazu ausgebildet ist, die in einem Simulationsschritt bestimmten Ausgangswerte an die Steuerungssimulationseinrichtung zu übertragen und die Steuerungssimulationseinrichtung dazu ausgebildet ist, diese Ausgangswerte als Eingangswerte für einen nachfolgend durchgeführten Simulationsschritt zu verwenden. Auf diese Weise wird eine Co-Simulation ermöglicht, um das Verhalten der gesteuerten Maschine oder Anlage vorherzusagen.

In einer weiteren Ausführungsform weist die Prozesssimulationseinrichtung einen Puffer zum Speichern der Eingangswerte auf. Hierbei ist es insbesondere vorgesehen, dass die Prozesssimulationseinrichtung dazu ausgebildet ist, zumindest einen der gespeicherten Eingangswerte in Abhängigkeit von einem Zeitpunkt, an welchem dieser bestimmt wurde, auszuwählen. Mithilfe der Vorrichtung kann in vorteilhafter Weise auch eine parallele Ausführung der Simulation des physikalischen Prozesses und der Simulation der Steuerung ermöglicht werden. Die Prozesssimulationseinrichtung weist den Puffer auf, in dem eine Sequenz von Eingangswerten gespeichert werden kann. Wenn mittels der Prozesssimulationseinrichtung eine neue Simulation gestartet wird beziehungsweise ein neuer Simulationszyklus begonnen wird, können aus dem Puffer diejenigen Eingangswerten ausgewählt werden, welche zu einem möglichst späten Zeitpunkt bestimmt wurden beziehungsweise welche den höchsten Zeitstempel aufweisen. Bei der Auswahl der Eingangswerte ist zudem zu berücksichtigen, dass diese zu einem Zeitpunkt vor dem Ergebniszeitpunkt bestimmt wurden. Für diese Simulation kann dann die Zeitdauer des zumindest einen Simulationsschritts an den Ergebniszeitpunkt angepasst werden.

Ferner ist es vorteilhaft, wenn die Prozesssimulationseinrichtung einen Puffer zum Speichern der Ausgangswerte aufweist, wobei die Prozesssimulationseinrichtung dazu ausgebildet ist, Ausgangswerten, welche nach dem Ergebniszeitpunkt bestimmt wurden, zu löschen. Für eine nachfolgende Simulation beziehungsweise einen nachfolgenden Simulationszyklus kann die Prozesssimulationseinrichtung den Puffer leeren und nur diejenigen Eingangswerte verwenden, welche diese zusammen mit dem Ergebniszeitpunkt erhalten hat. Somit arbeiten die Prozesssimulationseinrichtung und die Steuerungssimulationseinrichtung immer mit aktuellen Eingangswerten.

Wie bereits erläutert, weist die Steuerungssimulationseinrichtung bevorzugt einen Emulator zum Durchführen eines Steuerprogramms der Steuerung auf. Auf diesem Emulator kann das reale Steuerprogramm beziehungsweise die reale Steuerungssoftware der speicherprogrammierbaren Steuerung nachgebildet werden. Somit dann die Steuerung und/oder Regelung der Maschine oder Anlage realitätsnah simuliert werden.

In einer weiteren Ausführungsform ist es vorgesehen, dass die Vorrichtung eine Mehrzahl von Prozesssimulationseinrichtungen und/oder eine Mehrzahl von Steuerungssimulationseinrichtungen umfasst. Mit anderen Worten kann das Verfahren auf mehrere Prozesssimulationseinrichtungen und/oder mehrere Steuerungssimulationseinrichtungen erweitert werden. Auch hier ist es insbesondere vorgesehen, dass mit jeder der Steuerungssimulationseinrichtungen ein Ergebniszeitpunkt bestimmt wird und an die Steuerungssimulationseinrichtungen übertragen wird. Die Steuerungssimulationseinrichtungen kann die jeweilige zeitliche Dauer der Simulationsschritte an den Ergebniszeitpunkt anpassen.

Ein erfindungsgemäßes Verfahren dient zum Simulieren einer gesteuerten Maschine oder Anlage. Das Verfahren umfasst das Simulieren eines physikalischen Prozesses der Maschine oder Anlage durch Durchführen von Simulationsschritten mittels einer Prozesssimulationseinrichtung. Zudem beinhaltet das Verfahren das Simulieren einer Steuerung der Maschine oder Anlage durch Durchführen von Simulationsschritten mittels einer Steuerungssimulationseinrichtung. Ferner umfasst das Verfahren das Austauschen von in den jeweiligen Simulationsschritten bestimmten Ausgangswerte zwischen der Prozesssimulationseinrichtung und der Steuerungssimulationseinrichtung zum Simulieren der gesteuerten Maschine oder Anlage. Dabei ist es vorgesehen, dass mittels der Steuerungssimulationseinrichtung an die Prozesssimulationseinrichtung eine Information übertragen wird, welche einen Ergebniszeitpunkt für ein Ende eines mit der Steuerungssimulationseinrichtung durchgeführten Simulationsschritts beschreibt, und dass mittels der Prozesssimulationseinrichtung eine Zeitdauer zumindest eines der Simulationsschritte in Abhängigkeit von dem Ergebniszeitpunkt angepasst wird.

Die mit Bezug auf die erfindungsgemäße Vorrichtung vorgestellten bevorzugten Ausführungsformen und deren Vorteile gelten entsprechend für das erfindungsgemäße Verfahren.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen verwendbar, ohne den Rahmen der Erfindung zu verlassen.

Die Erfindung wird nun anhand von bevorzugten Ausführungsbeispielen sowie unter Bezugnahme auf die beigefügten Zeichnungen näher erläutert. Dabei zeigen:

FIG 1 eine Vorrichtung zum Simulieren einer gesteuerten Maschine oder Anlage gemäß dem Stand der Technik;

FIG 2 einen zeitlichen Ablauf von Simulationsschritten, welche mit der Vorrichtung gemäß FIG 1 durchgeführt werden;

FIG 3 eine Vorrichtung zum Simulieren einer gesteuerten Maschine oder Anlage gemäß einer Ausführungsform der Erfindung; und

FIG 4 einen zeitlichen Ablauf von Simulationsschritten, welche mit der Vorrichtung gemäß FIG 3 durchgeführt werden.

In den Figuren werden gleiche oder funktionsgleiche Elemente mit den gleichen Bezugszeichen versehen.

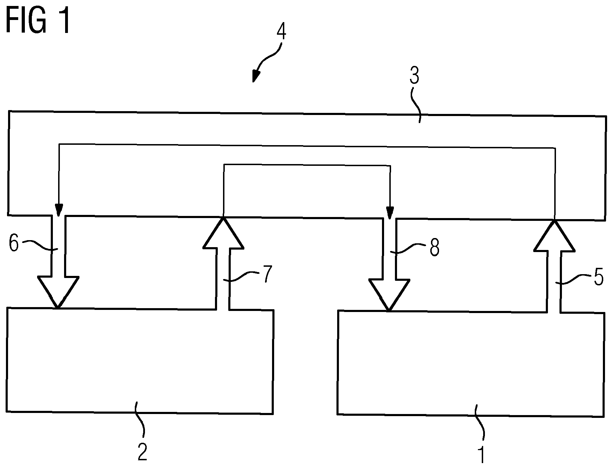

FIG 1 zeigt eine Vorrichtung 4 zum Simulieren einer gesteuerten Maschine oder Anlage gemäß dem Stand der Technik. Die Vorrichtung 4 umfasst eine Prozesssimulationseinrichtung 1, welche dazu dient, einen physikalischen Prozess der Maschine oder Anlage zu simulieren. Darüber hinaus umfasst die Vorrichtung 4 eine Steuerungssimulationseinrichtung 2, welche dazu dient, eine Steuerung, mittels welcher die Maschine oder Anlage gesteuert wird, zu simulieren. Bei der Steuerung, welche mittels der Steuerungssimulationseinrichtung 2 simuliert wird, kann es sich beispielsweise um eine speicherprogrammierbare Steuerung handeln. Die Steuerungssimulationseinrichtung 2 kann durch eine Software-Emulation beziehungsweise einen Emulator bereitgestellt werden. Vorliegend wird mittels der Prozesssimulationseinrichtung 1 und der Steuerungssimulationseinrichtung 2 eine Co-Simulation durchgeführt, um den Betrieb der gesteuerten Maschine oder Anlage nachzubilden.

Die Prozesssimulationseinrichtung 1 und die Steuerungssimulationseinrichtung 2 sind zur Datenübertragung miteinander verbunden. Mittels der Prozesssimulationseinrichtung 1 können Simulationsschritte $S_1$ durchgeführt werden und hierbei Ausgangswerte bestimmt werden. Dies ist vorliegend durch den Pfeil 5 veranschaulicht. Diese Ausgangswerte beschreiben physikalische Größen der Maschine oder Anlage. Die Ausgangswerte beziehungsweise die physikalischen Größen können beispielsweise eine Position, eine Geschwindigkeit und/oder eine Beschleunigung beschreiben. Die von der Prozesssimulationseinrichtung 1 bereitgestellten Ausgangswerte können von der Steuerungssimulationseinrichtung 2 als Eingabewerte empfangen werden (Pfeil 6). Mittels der Steuerungssimulationseinrichtung 2 können ebenfalls Ausgangswerte bereitgestellt werden. Dies ist vorliegend durch den Pfeil 7 gezeigt. Diese Ausgangswerte können beispielsweise einen elektrischen Strom, eine elektrische Spannung und/oder eine Frequenz beschreiben. Die von der Steuerungssimulationseinrichtung 2 bereitgestellten Ausgangswerte können wiederum von der Prozesssimulationseinrichtung 1 als Eingabewerte empfangen werden (Pfeil 8). In dem vorliegenden Beispiel sind die Prozesssimulationseinrichtung 1 und die Steuerungssimulationseinrichtung 2 über eine Komponente 3 miteinander verbunden. Mittels der Komponente 3 kann der Datenaustausch zwischen der Prozesssimulationseinrichtung 1 und der Steuerungssimulationseinrichtung 2 gesteuert werden. Auf diese Weise wird eine indirekte Datenverbindung zwischen der Prozesssimulationseinrichtung 1 und der Steuerungssimulationseinrichtung 2 realisiert.

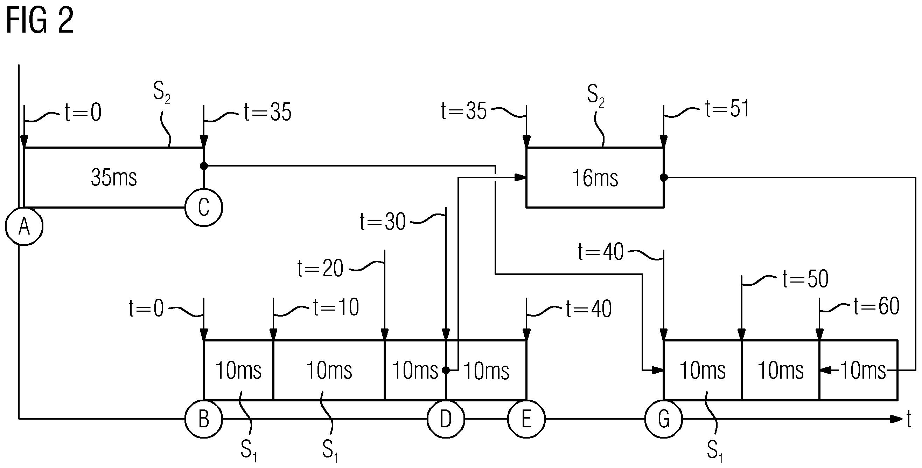

FIG 2 zeigt einen zeitlichen Ablauf der Simulationsschritte $S_1$, die mit der Prozesssimulationseinrichtung 1 und der Steuerungssimulationseinrichtung 2 durchgeführt werden. Dabei sind die jeweiligen Simulationsschritte $S_1$ bezüglich einer virtuellen Zeit t dargestellt. Die jeweils beschrieben Zeitdauern und Zeitpunkte in vorliegenden in ms (Millisekunden) angegeben. Da die Prozesssimulationseinrichtung 1 und die Steuerungssimulationseinrichtung 2 bei der Co-Simulation die Eingabewerte und/oder Ausgangswerte austauschen müssen, können diese nicht parallel betrieben werden, sondern die jeweiligen Simulationsschritte S werden sequenziell durchgeführt. Zu einem Zeitpunkt t = 0 wird die Steuerungssimulationseinrichtung 2 gestartet unter der Verwendung von initialen Eingangswerten (Ereignis A). Dabei wird ein Simulationsschritt $S_2$ durchgeführt und hierbei die Ausgangswerte berechnet. Dieser Simulationsschritt $S_2$ endet zu einem Zeitpunkt t = 35 (Ereignis C). Danach wird die virtuelle Zeit t für die Steuerungssimulationseinrichtung 2 angehalten beziehungsweise eingefroren.

Anschließend daran wird die Prozesssimulationseinrichtung 1 gestartet (Ereignis B). Dabei werden mit der Prozesssimulationseinrichtung 1 zeitlich aufeinanderfolgend Simulationsschritte $S_1$ durchgeführt, wobei vorliegend vier Simulationsschritte $S_1$ durchgeführt werden, deren jeweilige Zeitdauer 10 ms beträgt. Hierbei werden die Simulationsschritte $S_1$ solange durchgeführt, bis ein Zeitpunkt erreicht ist, der nach dem Zeitpunkt t = 35 liegt, nämlich der Zeitpunkt t = 40 (Ereignis E). Dabei können die in dem zuletzt durchgeführten Simulationsschritt $S_1$ bestimmten Ergebnisse nicht als Eingabewerte für die Steuerungssimulationseinrichtung 2 verwendet werden, da dadurch die korrekte Abfolge der Ereignisse verletzt werden würde. Daher wird das Ergebnis, welches zum Zeitpunkt t = 30 bestimmt wurde, als Eingangswert für die Steuerungssimulationseinrichtung 2 verwendet (Ereignis D). Aus dem gleichen Grund wird das Ergebnis der Steuerungssimulationseinrichtung 2, welches zu dem Zeitpunkt t = 35 bestimmt wurde, als Eingangswert für die Prozesssimulationseinrichtung 1 zum Zeitpunkt t = 40 verwendet (Ereignis G).

Nachfolgend wird mittels der Steuerungssimulationseinrichtung 2 ein weiterer Simulationsschritt $S_2$, welcher zu dem Zeitpunkt t = 51 endet (Ereignis F). Danach werden mittels der Prozesssimulationseinrichtung 1 drei aufeinanderfolgende Simulationsschritte $S_1$ mit einer jeweiligen Zeitdauer von 10 ms durchgeführt. Hier werden die Ergebnisse, welche die Steuerungssimulationseinrichtung 2 für den Zeitpunkt t = 51 bestimmt hat, als Eingangswerte für den Zeitpunkt t = 60 verwendet (Ereignis H). Dies führt insgesamt dazu, dass die beiden durchgeführten Simulationen mit Eingangswerten arbeiten, welche bezüglich der Zeit nicht synchronisiert sind. Daher wird ein Simulationsfehler der gesamten Co-Simulation unnötig groß werden.

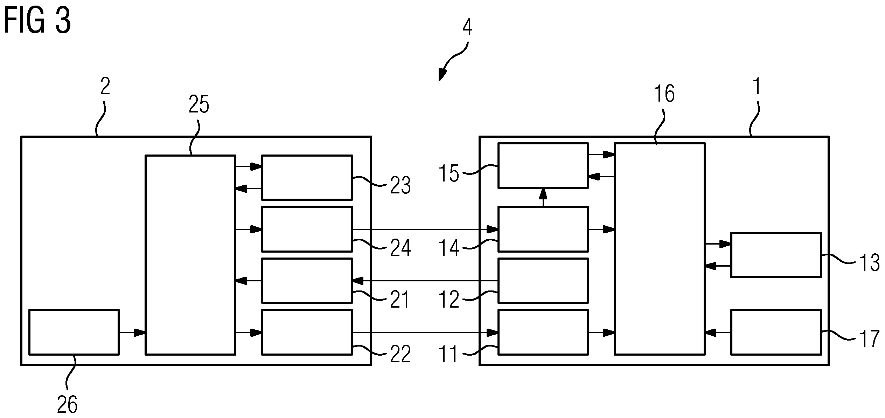

FIG 3 zeigt eine Vorrichtung 4 gemäß einer Ausführungsform der Erfindung. Auch diese Vorrichtung 4 umfasst eine Prozesssimulationseinrichtung 1 und eine Steuerungssimulationseinrichtung 2, welche zur Datenübertragung miteinander verbunden sind. Die Prozesssimulationseinrichtung 1 umfasst ein Ausführungssystem 16, mittels welchem die Simulation des physikalischen Prozesses der Maschine oder Anlage durchgeführt werden kann. Diesem Ausführungssystem 16 wird ein Simulationsmodell 17 beziehungsweise ein logisches Modell zugeführt. Des Weiteren umfasst die Prozesssimulationseinrichtung 1 einen Puffer 11 für die Eingangswerte und einem Puffer 12 für die Ausgangswerte. Darüber hinaus umfasst die Prozesssimulationseinrichtung 1 eine virtuelle Uhr 13, welche in Übereinstimmung mit der Durchführung der Simulation fortschreitet. Ferner umfasst die Prozesssimulationseinrichtung 1 einen Ereignisempfänger 14, welcher nachfolgend näher erläutert wird. Schließlich umfasst die Prozesssimulationseinrichtung 1 eine Einrichtung 15 zur Anpassung einer Schrittweite der Simulationsschritte $S_1$.

Die Steuerungssimulationseinrichtung 2 umfasst ein Ausführungssystem 25 zum Durchführen der Simulation, welche beispielsweise gemäß dem Standard IEC 61131 ausgebildet sein kann. Auch diesem Ausführungssystem 25 wird ein Simulationsmodell 26 zugeführt. Ferner umfasst die Steuerungssimulationseinrichtung 2 einen Puffer 21 für die Eingangswerte sowie einen Puffer 22 für die Ausgangswerte. Auch die Steuerungssimulationseinrichtung 2 umfasst eine virtuelle Uhr 23, welche fortschreitet, wenn die Simulation durchgeführt wird. Schließlich umfasst die Steuerungssimulationseinrichtung 2 einen Ereignisgenerator 24.

Dabei ist es vorgesehen, dass der Ereignisgenerator 24 jedes Mal ein Ereignissignal ausgibt, wenn ein Simulationsschritt $S_2$ mit der Steuerungssimulationseinrichtung 2 beendet wurde. Beispielsweise kann der Ereignisgenerator 24 ein Ereignissignal ausgeben, falls ein Hauptzyklus der Steuerung beziehungsweise der speicherprogrammierbaren Steuerung in der Simulation durchgeführt wurde. Dieses Ereignissignal umfasst dabei den entsprechenden Ergebniszeitpunkt ti der virtuellen Uhrzeit. Das Ereignissignal wird dabei an den Ereignisempfänger 14 der Prozesssimulationseinrichtung 1 übertragen. Ferner werden mittels der Steuerungssimulationseinrichtung 2 die Ausgangswerte für diesen Ergebniszeitpunkt ti zu der Prozesssimulationseinrichtung 1 übertragen. Nach dem Empfangen des Ereignissignals werden mittels der Prozesssimulationseinrichtung 1 mit der Einrichtung 15 die Schrittweiten beziehungsweise Zeitdauern der jeweiligen Simulationsschritte $S_1$ derart angepasst, dass diese zu dem Ergebniszeitpunkt ti ein Ergebnis liefern. In Abhängigkeit von dem Ausführungssystem 16 beziehungsweise einem Solver der Simulation können auch Zwischenschritte berechnet werden.

Um mittels der Einrichtung 15 die Schrittweite anzupassen werden numerische Solver erweitert. Beispielhaft wird vorliegend das explizite Euler-Verfahren verwendet, welches dazu dient, einfache Differentialgleichungen mit einem gegebenen Anfangswert zu lösen. Dabei kann das Problem in Form einer Differentialgleichung gegeben sein:

$$\frac{dy}{dt} = f(t, y), y(0) = y_0.$$

Dann kann die Näherung $y_k$ der aktuellen Funktionswerte $y(t_k)$ mit den diskreten Zeitschritten $t_k = t_0 + kh$ und der Schrittweite h berechnet werden:

$$y_{k+1} = y_k + hf(t_k, y_k).$$

Typischerweise wird die Schrittweite h so kontrolliert, dass die Schritte möglichst groß (aber begrenzt) sind und dass sichergestellt wird, dass der lokale Fehler unterhalb einer Schwelle ist:

$$\|y_{k+1} - y(t_{k+1})\| = c_n h_n \text{ mit } c_n \hat{h} = \varepsilon.$$

Hieraus ergibt sich:

$$h_{k+1} = h_k \cdot \sqrt{\frac{\varepsilon}{\|y_{k+1} - y(t_{k+1})\|}}.$$

Durch die Erweiterung des Algorithmus kann das folgenden eingeführt werden: Es sei ti die virtuelle Zeit des letzten Ereignisses. Für jeden der Simulationsschritte $S_1$ wird die Schrittweite $h_{k+1}$ und die hieraus resultierende virtuelle Zeit $t_{k+1}$ bestimmt. Falls $t_{k+1} > t_i$ ist, wird die Schrittweite zu $h_{k+1} = t_i - t_k$ gesetzt. Ferner wird das Ereignis verworfen.

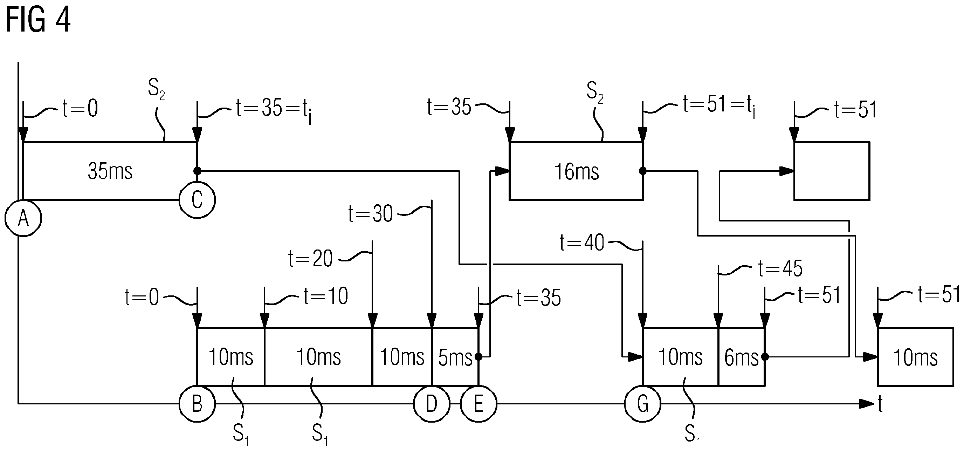

Hieraus ergibt sich insgesamt, dass die Prozesssimulationseinrichtung 1 und die Steuerungssimulationseinrichtung 2 immer mit aktuellen Eingangswerten arbeiten. Dies ist in FIG 4 dargestellt, welche einen zeitlichen Ablauf der Simulationsschritte $S_1$ und $S_2$ zeigt, die mit der Vorrichtung 4 gemäß FIG 3 durchgeführt werden. Dabei ist zu erkennen, dass mittels der Prozesssimulationseinrichtung 1 die zeitliche Dauer beziehungsweise die Schrittweite der zuerst durchgeführten Simulationsschritte $S_1$ angepasst wurde. Die zeitliche Dauer des letzten Simulationsschritts $S_1$ wurde von 10 ms auf 5 ms verringert. Somit enden die vier aufeinanderfolgenden Simulationsschritte $S_1$ insgesamt nach einem Zeitpunkt von t = 35 (Ereignis E), welcher dem Ergebniszeitpunkt ti entspricht. In gleicher Weise wurden die mit der Prozesssimulationseinrichtung 1 nachfolgend durchgeführten Simulationsschritte $S_1$ so angepasst, dass diese zu dem Zeitpunkt t = 51 enden.

Gemäß einer Erweiterung kann auch eine parallele Durchführung der Simulationen vorgesehen sein. Wie bereits beschrieben, umfasst die Prozesssimulationseinrichtung 1 den Puffer 11 für die Eingangswerte und den Zustand des Simulationsmodells. In diesem Puffer 11 können auch zuvor bestimmte Ergebnisse, die von der Steuerungssimulationseinrichtung 2 empfangen wurden, gespeichert werden. In Analogie zu dem zuvor beschriebenen Verfahren beziehungsweise Algorithmus, wird mittels Prozesssimulationseinrichtung 1 beim Empfangen des Ereignissignals der empfangene Ergebniszeitpunkt ti, der anhand der virtuellen Uhr 23 der Steuerungssimulationseinrichtung 2 bestimmt wird, mit der Zeit $t_{k+1}$ der virtuellen Uhr 13 der Prozesssimulationseinrichtung 1 verglichen. Die Prozesssimulationseinrichtung 1 löscht dann alle berechneten Ergebnisse beziehungsweise Ausgangswerte in dem Puffer 12, die nach dem Ergebniszeitpunkt ti bestimmt wurden. Im Anschluss daran führt die Prozesssimulationseinrichtung 1 eine neue Simulation durch, wobei hier die Eingangswerte mit dem größten Zeitstempel, die vor dem Ergebniszeitpunkt ti bestimmt wurden, verwendet werden. Für diese Simulation werden die Schrittweiten der Simulationsschritte $S_1$ in Abhängigkeit von dem Ergebniszeitpunkt ti - wie zuvor beschrieben - angepasst. Für die nächste Simulation kann leert die Prozesssimulationseinrichtung 1 dann den Puffer 11 und verwendet die Werte, die sie zusammen mit dem Ereignissignal erhalten hat. Somit wird es ermöglicht, dass die Prozesssimulationseinrichtung 1 und die Steuerungssimulationseinrichtung 2 immer mit aktuellen Werten arbeiten.

Das Verfahren kann auch auf mehrere Prozesssimulationseinrichtungen 1 und/oder mehrere Steuerungssimulationseinrichtungen 2 erweitert werden. In diesem Fall können alle Simulationseinrichtungen, die Daten mit zumindest einer Steuerungssimulationseinrichtung 2 austauschen, die Schrittweite beziehungsweise die zeitliche Dauer der Simulationsschritte $S_1$ wie zuvor beschrieben anpassen.

Vorliegend wird die zeitliche Dauer der Simulationsschritte $S_2$ der Steuerungssimulationseinrichtung nicht verändert, da diese das reale Verhalten einer speicherprogrammierbaren Steuerung gemäß der Norm IEC 61131 wiedergibt. Hier wird gefordert, dass die Steuerung (mit Ausnahme von speziellen Ereignissen) zu Beginn eines Hauptzyklus die Eingangswerte liest und alle Änderungen der Eingangswerte während der Durchführung des Hauptzyklus ignoriert. Im Gegensatz dazu sollte eine realistische Simulation des gesteuerten Prozesses den genauen Zeitpunkt berücksichtigen, zu dem die Steuerung den Prozess beeinflusst.

Bezugszeichenliste

| | |
|---|---|
| 1 | Prozesssimulationseinrichtung |
| 2 | Steuerungssimulationseinrichtung |
| 3 | Komponente |
| 4 | Vorrichtung |
| 5 | Pfeil |
| 6 | Pfeil |
| 7 | Pfeil |
| 8 | Pfeil |
| 11 | Puffer |
| 12 | Puffer |
| 13 | virtuelle Uhr |
| 14 | Ereignisempfänger |
| 15 | Einrichtung |
| 16 | Ausführungssystem |
| 17 | Simulationsmodell |
| 21 | Puffer |
| 22 | Puffer |
| 23 | virtuelle Uhr |
| 24 | Ereignisgenerator |
| 25 | Ausführungssystem |
| 26 | Simulationsmodell |
| A | Ereignis |
| B | Ereignis |
| C | Ereignis |
| D | Ereignis |
| E | Ereignis |
| F | Ereignis |
| G | Ereignis |
| H | Ereignis |
| $S_1$ | Simulationsschritt |
| $S_2$ | Simulationsschritt |
| t | Zeit |
| ti | Ergebniszeitpunkt |

Patentansprüche

1. Vorrichtung (4) zum Simulieren einer gesteuerten Maschine oder Anlage umfassend:

   - eine Prozesssimulationseinrichtung (1), welche dazu ausgebildet ist, zum Simulieren eines physikalischen Prozesses der Maschine oder Anlage Simulationsschritte ($S_1$) in Abhängigkeit

von einer virtuellen Zeit durchzuführen, und

- eine Steuerungssimulationseinrichtung (2), welche dazu ausgebildet ist, zum Simulieren einer Steuerung der Maschine oder Anlage Simulationsschritte ($S_2$) in Abhängigkeit von einer virtuellen Zeit durchzuführen,

- wobei die Steuerungssimulationseinrichtung eine virtuelle Uhr und einen Ereignisgenerator (24) umfasst,

- wobei die Prozesssimulationseinrichtung eine virtuelle Uhr und einen Ereignisempfänger (14) umfasst,

- wobei die Prozesssimulationseinrichtung (1) und die Steuerungssimulationseinrichtung (2) dazu ausgebildet sind, zum Simulieren der gesteuerten Maschine oder Anlage in den jeweiligen Simulationsschritten ($S_1$, $S_2$) bestimmte Ausgangswerte auszutauschen, wobei

- die Steuerungssimulationseinrichtung (2) dazu ausgebildet ist, an die Prozesssimulationseinrichtung (1) eine Information zu übertragen, welche einen virtuellen Ergebniszeitpunkt (ti) für ein Ende eines mit der Steuerungssimulationseinrichtung (2) durchgeführten Simulationsschritts ($S_2$) beschreibt, und

- die Prozesssimulationseinrichtung (1) dazu ausgebildet ist, eine Zeitdauer zumindest eines Simulationsschritts ($S_1$) in Abhängigkeit von dem Ergebniszeitpunkt (ti) anzupassen,

- wobei der Ereignisgenerator (24) ausgebildet ist, ein Ereignissignal zu erzeugen, wenn ein Simulationsschritt mit der Steuerungssimulationseinrichtung beendet wurde, wobei das Ereignissignal den Ergebniszeitpunkt (ti) beschreibt, und die Prozesssimulationseinrichtung (1) einen Ereignisempfänger (14) zum Empfangen des Ereignissignals aufweist.

2. Vorrichtung (4) nach Anspruch 1, **dadurch gekennzeichnet, dass** die Prozesssimulationseinrichtung (1) dazu ausgebildet ist, die Zeitdauer des zumindest einen Simulationsschritts ($S_1$), welcher mit dieser durchgeführt wird, so anzupassen, dass der zumindest eine Simulationsschritt ($S_1$) zu dem Ergebniszeitpunkt (ti) endet.

3. Vorrichtung (4) nach Anspruch 1 oder 2, **dadurch gekennzeichnet, dass** die Prozesssimulationseinrichtung (1) eine Einrichtung (15) aufweist, welche dazu ausgebildet ist, die zeitliche Dauer des zumindest einen Simulationsschritts ($S_1$) in Abhängigkeit von dem Ergebniszeitpunkt (ti) anzupassen.

4. Vorrichtung (4) nach einem der vorhergehenden Ansprüche, **dadurch gekennzeichnet, dass** die Steuerungssimulationseinrichtung (2) dazu ausgebildet ist, die bestimmten Ausgangswerte an die Prozesssimulationseinrichtung (1) zu übertragen und die Prozesssimulationseinrichtung (1) dazu ausgebildet ist, diese Ausgangswerte als Eingangswerte für zumindest einen durchgeführten Simulationsschritt ($S_1$) zu verwenden.

5. Vorrichtung (4) nach Anspruch 4, **dadurch gekennzeichnet, dass** die Prozesssimulationseinrichtung (1) einen Puffer (11) zum Speichern der Eingangswerte aufweist.

6. Vorrichtung (4) nach Anspruch 5, **dadurch gekennzeichnet, dass** die Prozesssimulationseinrichtung (1) dazu ausgebildet ist, zumindest einen der gespeicherten Eingangswerte in Abhängigkeit von einem Zeitpunkt, an welchem dieser bestimmt wurde, auszuwählen.

7. Vorrichtung (4) nach einem der vorhergehenden Ansprüche, **dadurch gekennzeichnet, dass** die Prozesssimulationseinrichtung (1) einen Puffer (12) zum Speichern der Ausgangswerte aufweist, wobei die Prozesssimulationseinrichtung (1) dazu ausgebildet ist, Ausgangswerten, welche nach dem Ergebniszeitpunkt ($t_i$) bestimmt wurden, zu löschen.

8. Vorrichtung (4) nach einem der vorhergehenden Ansprüche, **dadurch gekennzeichnet, dass** die Steuerungssimulationseinrichtung (2) einen Emulator zum Durchführen eines Steuerprogramms der Steuerung aufweist.

9. Vorrichtung (4) nach einem der vorhergehenden Ansprüche, **dadurch gekennzeichnet, dass** die Vorrichtung (4) eine Mehrzahl von Prozesssimulationseinrichtungen (1) und/oder eine Mehrzahl von Steuerungssimulationseinrichtungen (2) umfasst.

10. Verfahren zum Simulieren einer gesteuerten Maschine oder Anlage mit den Schritten:

- Simulieren eines physikalischen Prozesses der Maschine oder Anlage durch Durchführen von Simulationsschritten ($S_1$) in Abhängigkeit von einer virtuellen Zeit mittels einer Prozesssimulationseinrichtung (1), wobei die Prozesssimulationseinrichtung eine virtuelle Uhr und einen Ereignisempfänger (14) umfasst,

- Simulieren einer Steuerung der Maschine oder Anlage durch Durchführen von Simulationsschritten ($S_2$) mittels einer Steuerungssimulationseinrichtung (2), wobei die Steuerungssimulationseinrichtung eine virtuelle Uhr und einen Ereignisgenerator (24) umfasst und

- Austauschen von in den jeweiligen Simulationsschritten ($S_1$, $S_2$) bestimmten Ausgangswerten zwischen der Prozesssimulationseinrichtung (1) und der Steuerungssimulationseinrichtung (2) zum Simulieren der gesteuerten Maschine oder Anlage, wobei
- mittels der Steuerungssimulationseinrichtung (2) an die Prozesssimulationseinrichtung (1) eine Information übertragen wird, welche einen virtuellen Ergebniszeitpunkt (ti) für ein Ende eines mit der Steuerungssimulationseinrichtung (2) durchgeführten Simulationsschritts ($S_2$) beschreibt, und
- mittels der Prozesssimulationseinrichtung (1) eine Zeitdauer zumindest eines der Simulationsschritte ($S_1$) in Abhängigkeit von dem Ergebniszeitpunkt (ti) angepasst wird
- mittels des Ereignisgenerators (24) ein Ereignissignals erzeugt wird, wenn ein Simulationsschritt mit der Steuerungssimulationseinrichtung beendet wurde, wobei das Ereignissignal den Ergebniszeitpunkt ($t_i$) beschreibt, und die Prozesssimulationseinrichtung (1) einen Ereignisempfänger (14) zum Empfangen des Ereignissignals aufweist.

**Claims**

1. Device (4) for simulating a controlled machine or installation, comprising:

   - a process simulation apparatus (1) that is designed to perform simulation steps ($S_1$) depending on a virtual time so as to simulate a physical process of the machine or installation, and
   - a controller simulation apparatus (2) that is designed to perform simulation steps ($S_2$) depending on a virtual time so as to simulate a controller of the machine or installation,
   - wherein the controller simulation apparatus comprises a virtual clock and an event generator (24),
   - wherein the process simulation apparatus comprises a virtual clock and an event receiver (14),
   - wherein the process simulation apparatus (1) and the controller simulation apparatus (2) are designed to exchange particular output values so as to simulate the controlled machine or installation in the respective simulation steps ($S_1$, $S_2$), wherein
   - the controller simulation apparatus (2) is designed to transmit an item of information to the process simulation apparatus (1), which item of information describes a virtual result time ($t_i$) for an end of a simulation step ($S_2$) performed using the controller simulation apparatus (2), and
   - the process simulation apparatus (1) is designed to adjust a duration of at least one simulation step ($S_1$) depending on the result time ($t_i$),
   - wherein the event generator (24) is designed to generate an event signal when a simulation step using the controller simulation apparatus has ended, wherein the event signal describes the result time ($t_i$), and the process simulation apparatus (1) has an event receiver (14) for receiving the event signal.

2. Device (4) according to Claim 1, **characterized in that** the process simulation apparatus (1) is designed to adjust the duration of the at least one simulation step ($S_1$) that is performed thereby such that the at least one simulation step ($S_1$) ends at the result time ($t_i$).

3. Device (4) according to Claim 1 or 2, **characterized in that** the process simulation apparatus (1) has an apparatus (15) that is designed to adjust the duration of the at least one simulation step ($S_1$) depending on the result time ($t_i$).

4. Device (4) according to one of the preceding claims, **characterized in that** the controller simulation apparatus (2) is designed to transmit the determined output values to the process simulation apparatus (1), and the process simulation apparatus (1) is designed to use these output values as input values for at least one simulation step ($S_1$) that is performed.

5. Device (4) according to Claim 4, **characterized in that** the process simulation apparatus (1) has a buffer (11) for storing the input values.

6. Device (4) according to Claim 5, **characterized in that** the process simulation apparatus (1) is designed to select at least one of the stored input values depending on a time at which said input value was determined.

7. Device (4) according to one of the preceding claims, **characterized in that** the process simulation apparatus (1) has a buffer (12) for storing the output values, wherein the process simulation apparatus (1) is designed to delete output values that were determined after the result time ($t_i$).

8. Device (4) according to one of the preceding claims, **characterized in that** the controller simulation apparatus (2) has an emulator for performing a control program of the controller.

9. Device (4) according to one of the preceding claims, **characterized in that** the device (4) comprises a multiplicity of process simulation apparatuses (1) and/or a multiplicity of controller simulation apparatuses (2).

10. Method for simulating a controlled machine or installation, having the steps:

- simulating a physical process of the machine or installation by performing simulation steps $(S_1)$ depending on a virtual time by way of a process simulation apparatus (1), wherein the process simulation apparatus comprises a virtual clock and an event receiver (14),
- simulating a controller of the machine or installation by performing simulation steps $(S_2)$ by way of a controller simulation apparatus (2), wherein the controller simulation apparatus comprises a virtual clock and an event generator (24), and
- exchanging output values, determined in the respective simulation steps $(S_1, S_2)$, between the process simulation apparatus (1) and the controller simulation apparatus (2) so as to simulate the controlled machine or installation, wherein
- an item of information is transmitted to the process simulation apparatus (1) by way of the controller simulation apparatus (2), which item of information describes a virtual result time $(t_i)$ for an end of a simulation step $(S_2)$ performed using the controller simulation apparatus (2), and
- a duration of at least one of the simulation steps $(S_1)$ is adjusted depending on the result time $(t_i)$ by way of the process simulation apparatus (1),
- an event signal is generated by way of the event generator (24) when a simulation step using the controller simulation apparatus has ended, wherein the event signal describes the result time $(t_i)$, and the process simulation apparatus (1) has an event receiver (14) for receiving the event signal.

**Revendications**

1. Système (4) de simulation d'une machine ou d'une installation commandée, comprenant :

   - un dispositif (1) de simulation de processus, qui est constitué pour effectuer, pour simuler un processus physique de la machine ou de l'installation, des stades $(S_1)$ de simulation en fonction d'un temps virtuel, et
   - un dispositif (2) de simulation de commande, qui est constitué pour effectuer, pour simuler une commande de la machine ou de l'installation, des stades $(S_2)$ de simulation en fonction d'un temps virtuel,
   - dans lequel le dispositif de simulation de commande comprend une horloge virtuelle et un générateur (24) d'événement,
   - dans lequel le dispositif de simulation de processus comprend une horloge virtuelle et un récepteur (14) d'événement,
   - dans lequel le dispositif (1) de simulation de processus et le dispositif (2) de simulation de commande sont constitués pour échanger, pour simuler la machine ou l'installation commandée, des valeurs de sortie déterminées dans les stades $(S_1, S_2)$ de simulation respectifs, dans lequel

   - le dispositif (2) de simulation de commande est constitué pour transmettre au dispositif (1) de simulation de processus une information, qui décrit un instant $(t_i)$ de résultat virtuel d'une fin d'un stade $(S_2)$ de simulation effectué par le dispositif (2) de simulation de commande, et
   - le dispositif (1) de simulation de processus est constitué pour adapter une durée d'au moins un stade $(S_1)$ de simulation en fonction de l'instant $(t_i)$ de résultat,
   - dans lequel le générateur (24) d'événement est constitué pour produire un signal d'événement, lorsqu'il a été mis fin à un stade de simulation par le dispositif de simulation de commande, le signal d'événement décrivant l'instant $(t_i)$ de résultat et le dispositif (1) de simulation de processus ayant un récepteur (14) d'événement pour la réception du signal d'événement.

2. Système (4) suivant la revendication 1, **caractérisé en ce que** le dispositif (1) de simulation de processus est constitué pour adapter la durée du au moins un stade $(S_1)$ de simulation, qui est effectué par celui-ci, de manière à ce que le au moins un stade $(S_1)$ de simulation se termine à l'instant $(t_i)$ de résultat.

3. Système (4) suivant la revendication 1 ou 2, **caractérisé en ce que** le dispositif (1) de simulation de processus a un dispositif (15), qui est constitué pour adapter la durée dans le temps du au moins un stade $(S_1)$ de simulation en fonction de l'instant $(t_i)$ de résultat.

4. Système (4) suivant l'une des revendications précédente, **caractérisé en ce que** le dispositif (2) de simulation de commande est constitué pour transmettre les valeurs de sortie déterminées au dispositif (1) de simulation de processus et le dispositif (1) de simulation de processus est constitué pour utiliser ces valeurs de sortie, comme valeurs d'entrée pour au moins un stade (S1) de simulation de effectué.

5. Système (4) suivant la revendication 4, **caractérisé en ce que** le dispositif (1) de simulation de processus a un tampon (11) de mise en mémoire des valeurs d'entrée.

6. Système (4) suivant la revendication 5, **caractérisé en ce que** le dispositif (1) de simulation de processus est constitué pour sélectionner au moins l'une des valeurs d'entrée mises en mémoire en fonction d'un instant où celle-ci a été déterminée.

**7.** Système (4) suivant l'une des revendications précédentes, **caractérisé en ce que** le dispositif (1) de simulation de processus a un tampon (12) de mise en mémoire des valeurs de sortie, le dispositif (1) de simulation de processus étant constitué pour effacer des valeurs de sortie, qui ont été déterminées après l'instant ($t_i$) de résultat.

**8.** Système (4) suivant l'une des revendications précédentes, **caractérisé en ce que** le dispositif (2) de simulation de commande a un émulateur pour effectuer un programme de commande de la commande.

**9.** Système (4) suivant l'une des revendications précédentes, **caractérisé en ce que** le système (4) comprend une pluralité de dispositifs (1) de simulation de processus et/ou une pluralité de dispositifs (2) de simulation de commande.

**10.** Procédé de simulation d'une machine ou d'une installation commandée, comprenant les stades :

- simulation d'un processus physique de la machine ou de l'installation, en effectuant des stades ($S_1$) de simulation en fonction d'un temps virtuel au moyen d'un dispositif (1) de simulation de processus, le dispositif de simulation de processus comprenant une horloge virtuelle et un générateur (14) d'événement,
- Simulation d'une commande de la machine ou de l'installation en effectuant des stades ($S_2$) de simulation au moyen d'un dispositif (2) de simulation de commande, le dispositif de simulation de commande comprenant une horloge virtuelle et un générateur (24) d'événement et
- échange de valeurs de sortie déterminées dans les stades ($S_1$, $S_2$) respectifs de simulation entre le dispositif (1) de simulation de processus et le dispositif (2) de simulation de commande pour la simulation de la machine ou de l'installation commandée,
dans lequel
- au moyen du dispositif (2) de simulation de commande, on transmet au dispositif (1) de simulation de processus une information, qui décrit un instant ($t_i$) de résultat virtuel d'une fin d'un stade ($S_2$) de simulation effectué par le dispositif (2) de simulation de commande, et
- au moyen du dispositif (1) de simulation de processus, on adapte une durée d'au moins l'un des stades ($S_1$) de simulation en fonction de l'instant ($t_i$) de résultat,
- au moyen du générateur (24) d'événement, on produit un signal d'événement, s'il a été mis fin à un stade de simulation par le dispositif de simulation de commande, le signal d'événement décrivant l'instant ($t_i$) de résultat et le dispositif (1) de simulation de processus ayant un récepteur (14) d'événement pour la réception du signal d'événement.

FIG 1

FIG 2

EP 3 521 949 B1

FIG 3

EP 3 521 949 B1

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007026502 A1